# EUROPEAN PATENT APPLICATION

(11) **EP 1 650 602 A1**
(43) Date of publication of application: **26.04.2006**
(21) Application number: 04025105.0
(22) Date of filing: 22.10.2004
(51) Int. Cl.: G03F 7/20

(54) **A system and a method for generating periodic and /or quasi-periodic pattern on a sample**

(71) Applicant: PAUL SCHERRER INSTITUT, 5232 Villigen PSI (CH)
(72) Inventor: Solak, Harun H., Dr., 5200 Brugg (CH)
(74) Representative: Fischer, Michael

(57) **Abstract**

It is the aim of this invention to provide a system and a method to achieve periodic and quasi-periodic patterns with periods in the 5-100 nm range in a cost effective way. Of course, the system has also general applicability to patterns with larger periods.

This aim is achieve by the present invention which discloses a system for generating periodic and/or quasi-periodic pattern on a sample by using an interference lithography technique; the system comprising:
a) a photon source emitting photons being substantially incoherent in time;
b) a mask having a periodic or quasi-periodic pattern that corresponds to the desired pattern; said mask being disposed at a first distance from the photon source or after intermediate optical elements such as collimators, collectors, mirrors, lenses, filters and apertures.;
c) a sample holder for holding the sample being disposed in a second distance from the mask on the side opposite to the photon source, thereby the second distance is chosen to be in a range where the intensity distribution is substantially stationary and distance-invariant.

## Description

The present invention relates to a system and a method for generating periodic and/or quasi-periodic pattern on a sample using space-invariant interference lithography.
Periodic and/or quasi periodic structures find extensive use in many areas of micro- and nano-technology. Optical gratings, diffraction lenses, patterned magnetic media for data storage, integrated electronic circuits, sensors and display devices are some examples where periodic structures are used. Subwavelength optical elements, templates for nano-imprint lithogprahy, templates for guided self assembly, templates for crystallization, arrays of nanowires, nanodots, process developments for the next generation lithography technologies, in particular Extreme Ultraviolett Lithography (EUVL), catalysis and field emission substrates.

These uses are expected to grow significantly as novel properties of materials with nanometer scale dimensions are exploited in such or other new applications yet not known. Lithographic methods are usually used to fabricate such periodic structures. However, currently available lithographic methods for fabricating patterns with periods less than 100 nm are too costly for widespread exploitation.

Interference lithography (IL) is a known technique for creating periodic structures. Lasers in the visible or ultraviolet regions and synchrotrons in the extreme-ultraviolet (EUV) range are employed as light sources in IL.

Periodic, quasi-periodic [1], curved [2] one and two-dimensional patterns can be produced with IL.

Most IL methods require light sources with a high degree of spatial and/or temporal coherence. Lasers operating in the visible and ultraviolet region often possess one or both of these properties and, therefore, they are used in the vast majority of IL applications. An achromatic IL method with relaxed requirements with respect to these two properties has been described [3]. However, this technique requires very high power from the source as the beam is diffracted by two consecutive gratings with limited efficiency. Moreover, the depth of focus of the obtained pattern is limited by the spatial coherence of the source.

A related technique to IL is Spatial Frequency Multiplication (SFM), where the substrate to be patterned is placed behind a transmission optical grating (mask) [4]. In a plane parallel to the grating and at a certain distance away from the grating, the intensity of light has a periodicity that is a multiple of the periodicity of the mask. In SFM, the sample is placed in a plane where the desired intensity distribution exists and the intensity distribution is recorded in a photosensitive film. In this way, new gratings with spatial frequencies that are multiples of the original diffraction grating can be formed. In the described technique, the intensity distribution depends sensitively on the distance from the grating. Therefore, very precise positioning and alignment of the sample to be patterned with respect to the mask (narrow field) is required. This "depth of field" limitation becomes much more restrictive as the period of the mask is reduced. Moreover, this limitation excludes the use of the technique for creating patterns on substrates with topographical features that are larger than the depth of field.

It is therefore the aim of this invention to provide a system and a method to achieve one-dimensional and two-dimensional, periodic and quasi-periodic patterns with periods in the 10-100 nm range in a cost effective way. Of course, the system has also general applicability to patterns with larger periods.

This aim is achieve by the present invention which discloses a system for generating periodic and/or quasi-periodic pattern on a sample by using an interference lithography technique; the system comprising:
a) a photon source emitting photons being substantially incoherent in time;
b) a mask having a periodic or quasi-periodic pattern that corresponds to the desired pattern; said mask being disposed at a first distance from the photon source; or after intermediate optical elements such as collimators, collectors, mirrors, lenses, filters and apertures.
c) a sample holder for holding the sample being disposed in a second distance from the mask on the side opposite to the photon source, thereby the second distance is chosen to be in a range where the intensity distribution is substantially stationary and distance-invariant.

With respect to the method, a method for generating periodic and/or quasi-periodic pattern on a sample (S) by using an interference lithography technique is provided, comprising the steps of:
a) providing a photon source (P) emitting photons being substantially incoherent in time;
b) providing a mask (M) having a periodic or quasi-periodic pattern that corresponds to the desired pattern;
c) disposing said mask (M) at a first distance from the photon source (P) or after intermediate optical elements such as collimators, collectors, mirrors, lenses, filters and apertures;
d) providing a sample holder for holding the sample (S)
e) disposing the sample (S) at a second distance from the mask (M) on the side opposite to the photon source (P),
f) choosing the second distance to be in a range where the intensity distribution is substantially stationary and distance-invariant; and
g) illuminating the sample (S) with the radiation originating from the photon source (P) and passing through the mask (M).

This system and this method deliver periodic and/or quasi-periodic patterns in a cost-effective way since the source has not to be coherent in time and the sample can be easily positioned within the stationary range.

The light illuminating the mask needs to have some degree of spatial coherence depending on the pattern on the mask and the distance of the sample from the mask. The image on the sample is due to the interference of a number of diffracted beams generated by the periodic patterns on the mask. The desired intensity pattern will require a certain number of these diffraction orders to be mutually coherent with respect to each other. Therefore, the spatial coherence length of the illumination has to be large enough to ensure the mutualcoherence of these diffracted beams. This means that the illuminating beam does not necessarily have to be spatially coherent over the whole mask surface. Therefore sources, which do not provide illumination with a high degree of spatial coherence, such as laser produced plasma or gas discharge sources can be used with the described system and method. On the other hand fully spatially coherent beams, such as the ones available from synchrotron radiation sources, can also be used.

For use with the most currently known applications the system may be operated with the photon source emitting dominantly photons having a wavelength in the range of 1 to 100 nm, preferably 10 to 50 nm which allow to generate pattern having a periodicity being significantly smaller.
Cost-effective and available photon source within the current invention may be the use of a plasma source, such as a laser produced plasma source (LPP source), or a gas discharge source.

In order to satisfy the partially very sophisticated demands to the desired pattern, the systems may be operated with masks having a linear grating or a two-dimensional linear grating or a two-dimensional partially non-linear grating or a two-dimensional periodically circular grating or a two-dimensional non-periodically circular grating. Even a combination of different masks might be suitable for designing the desired shape of the pattern. The periodicity of the said patterns can be varied along one or more directions.

The system allows effective protection of the mask from effects such as contamination and deformation and damage due to excessive haeating. This is made possible by the large enough room on both sides of the mask for the installation of protective elements such as pellicles and cooling gases. The large distances also protect the mask from accidental contact and resulting damage.

Due to the fact that LPP sources or gas discharge sources can be used with the present invention, the photon source may have a substantially isotropic radiation characteristic, and a plurality of mask/sample holder arrangements are displaced around the photon source. Therefore, the throughput available from a single source can be increased by using a multiplexing scheme or similar multiplication means.

Examples of the invention are hereinafter described with reference to the drawings. In the drawings:
- Figure 1: is a schematic view on a system for generating periodic and/or quasi periodic nano-structures on a sample;
- Figure 2: is the calculation of an image generated by mask having a linear grating;
- Figure 3: is the calculation of the generation of a z-invariant image behind a mask having a first two-dimensional grating;
- Figure 4: is the calculation of the generation of a z-invariant image behind a mask having a second two-dimensional grating;
- Figure 5: is the calculation of the generation of a z-invariant image behind a mask having a third two-dimensional grating;
- Figure 6: is the schematic explanation of the spatial coherence requirement of the described method;
- Figure 7: is a schematic layout of a possible lithography system using a wideand light source such as a laser plasma or gas discharge source working in the EUV range; and
- Figure 8: is a schematic layout of a possible system where four exposure systems are put together around a single source.

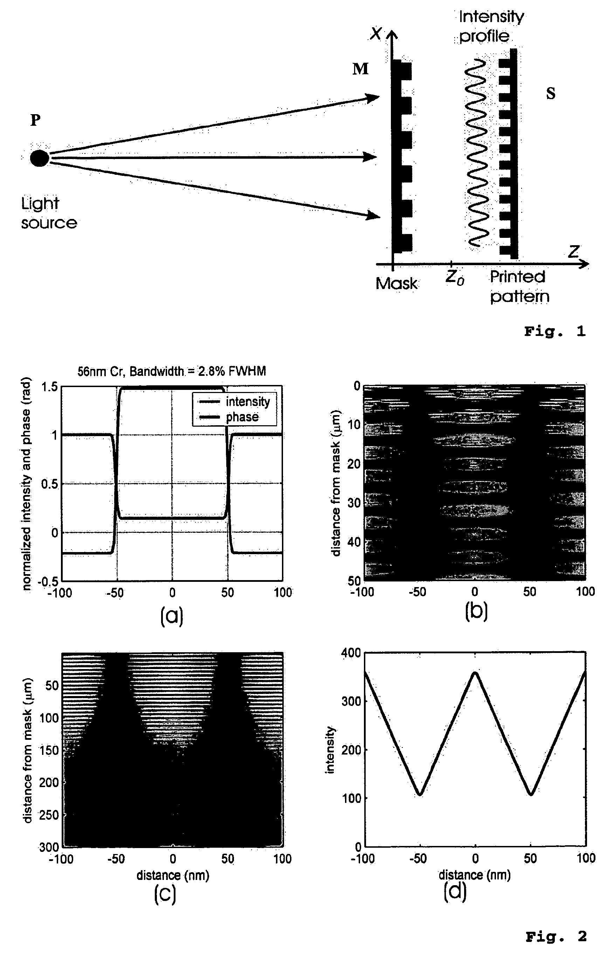

The space-invariant system and method disclosed in this invention use masks M with periodic or quasi-periodic transmission structures. The mask M is illuminated with radiation y originating from a photon source P that has limited spatial and temporal coherence properties (Figure 1). The image obtained at distances larger than a certain value Z₀ is independent of the distance, in other words, it is space-invariant or with respect to the illustrated z-axis it is z-invariant. The intensity pattern is therefore independent of the distance from the mask beyond a certain z₀ value. The recorded image has periodicity related to the pattern of the mask M. However, it is not necessarily a replica of the mask M or a frequency-multiplied version of it. In this example, the recorded pattern has half the period of the mask M. The image for each mask design can be determined through optical calculations. Furthermore, the same image can be used to record different shapes by applying different exposure doses to the recording medium (photoresist) which is disposed on a sample S.

Figure 2 shows the image calculated behind a mask having a linear grating. Simulation results showing the formation of the z-invariant image. Part (a) indicates the transmission behaviour of the mask M. The mask M is formed of 200 nm period Cr bars with approximately 50% duty cycle. The Cr thickness is 56 nm and the illuminating radiation has a central wavelength of 13.4 nm and 2.8% bandwidth (FWHM). In all parts (a) to (d) of the figure the horizontal axis corresponds to one period of the mask M, which is 200 nm. As shown in part (b) the intensity distribution immediately behind the mask M showing the periodic dependence of the pattern on z. Even in that limited range some of the high frequency variations in the intensity profile die down after a short distance from the mask. Part (c) illustrates the intensity distribution over a larger z range. The periodic variation of the intensity profile vanishes for distances greater than about 200 µm. High intensity regions are indicated by brighter grey tones. Part (d) shows the image profile obtained after the periodic oscillations die down. This image has half the period of the original Cr pattern in the mask M. The modulation in this image is sufficient to record sharp line/space features in a photoresist sample S.

Fig. 2 illustrates that the image has a strong periodic dependence on the distance from the mask plane as seen in Figures 2b and 2c. However, this dependence dies down after about 200 µm away from the mask M. From that point on, the intensity profile is constant as shown in Figure 2d. The modulation of intensity and the shape of the final profile depend on the mask pattern. In particular, the duty cycle of the periodic pattern in the mask M and the absorbing and phase shifting properties of the material used to make the grating bars affect the final image profile.

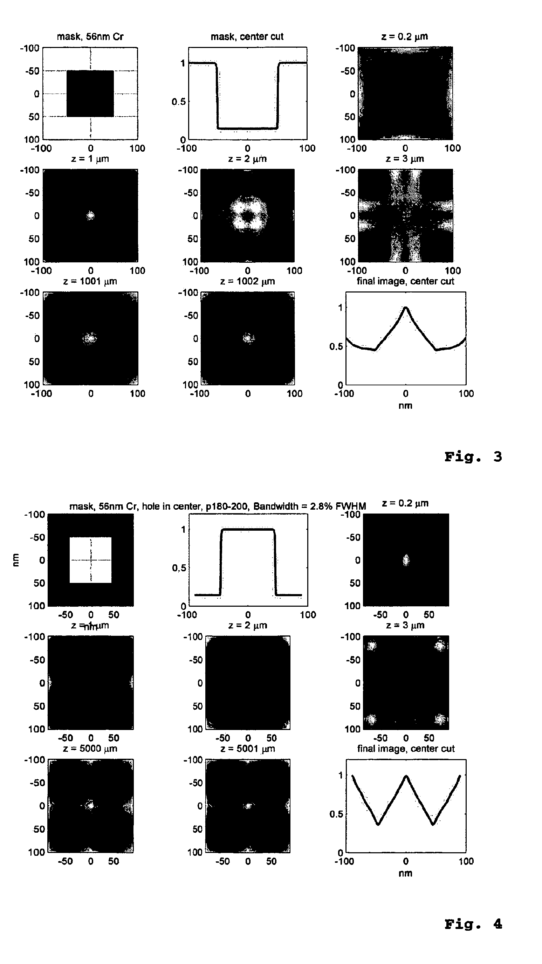

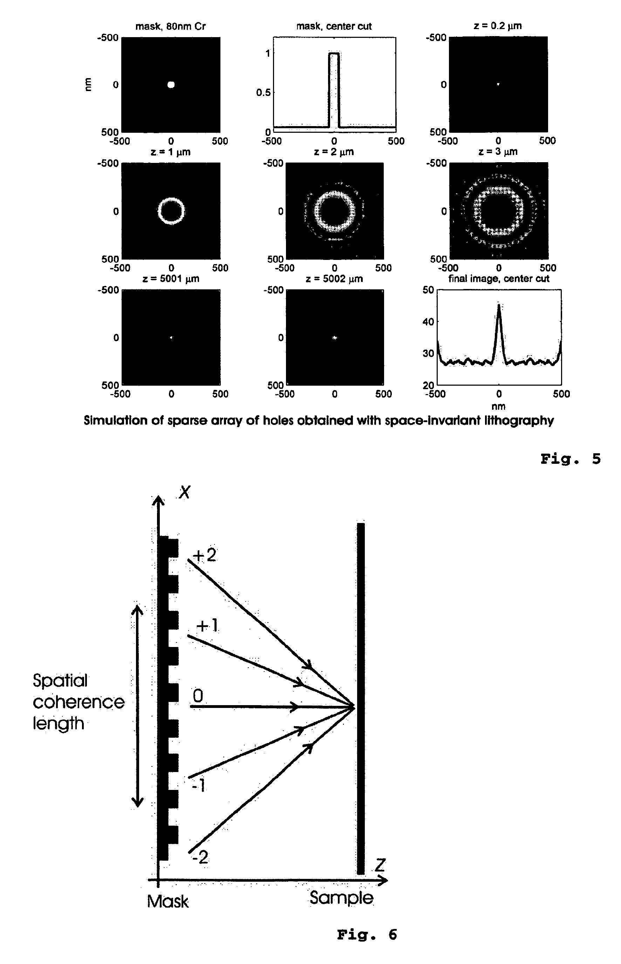

Two-dimensional z-invariant periodic patterns can be obtained and recorded using the same principle. Two examples are shown in Figures 3 and 4. The strikingly different images in these two figures are obtained by a slight change in the mask layout. In both cases, the mask consists of holes in a Cr film on a rectangular grid. In the first case according to Fig. 3 the periods of the grid in the horizontal and vertical directions are identical. This leads to the coherent summation of diffracted orders in these two directions (as well as mixed orders in other directions). In the second case according to Fig. 4, the two periods (horizontal and vertical) are slightly different, which qualitatively changes the image, as various diffracted orders can no longer be added coherently. This points to an important tool that can be used to control the images in the described achromatic interference technique. Many different two-dimensional images can be obtained such as hexagonal arrays, quasi-periodic and curved patterns with the described technique. It is possible to vary the periodicity of a pattern along one or more directions. For example variable period linear gratings, Fresnel Zone Plates or variable period two-dimensional dot arrays can be obtained. In another variation the variable periodicity can be combined with curved structures to obtain arrays of dots on concentric circular tracks.

In detail now, Fig. 3 illustrates in nine parts a) to i) the simulation results showing the formation of a two-dimensional z-invariant image. Part (a) is the transmission of the mask. The mask is formed of 100x100 nm² size holes on a 200 nm period square grid. One period of the square grid is shown. The Cr thickness is 56 nm. Part (b) is the cross-section of the mask transmission along a line cutting through the center of the image in part (a) At very close distances behind the mask the image is tremendously depending form this distance as it can be seen from parts (c), (d), (e) and (f) which are calculated for a distance of 0.2 µm, 1 µm, 2µm and 3µm resp. The parts (g) and (h) are calculated for a distance of 1000 µm and 1001 µm resp. and show the z-invariant behaviour at that distance where the image is z-invariant or in other words stationary. The image consists of an array of intensity peaks on a 45° tilted square grid. The period of the image is equal to the mask period divided by √2, i.e. 141 nm.

Fig. 4 in detail shows the simulation results for a mask pattern that is slightly different than the one in Figure 3. In this case the periods of the mask pattern in the horizontal and vertical directions are not the same; they are 180 nm and 200 nm respectively. The image is dramatically different, since the diffracted orders in the horizontal and vertical directions do not interfere coherently any more. The image consists of a square array of intensity peaks with half of the mask period. This configuration is especially useful as it produces a higher resolution pattern. Again, the z-invariance of the image is not given for the short distance as indicated in parts (c), (d), (e) and (f) which are calculated for a distance of 0.2 µm, 1 µm, 2µm and 3µm resp. The parts (g) and (h) are calculated for a distance of 5000 µm and 5001 µm resp. and show the z-invarinat behaviour at that distance where the image is z-invariant or in other words stationary.

Fig. 5 in detail shows the simulation results for a mask pattern that is different than the ones in Figure 3 and Figure 4. In this case the size of the feature in the mask is much smaller than the period. The mask consists of 80 nm diameter holes on a 1 micrometer period square grid. The stationary image at large z consists of sharp intensity peaks on a 45° tilted square grid with a periodicity of 707 nm. In addition the holes are connected with bright lines. This image can be used to print sparse arrays of nanometer size structures with a period that is much larger than the structure size. Alternatively it can be used to print a mesh like structure with horizontal, vertical and diagonal lines. Again, the z-invariance of the image is not given for the short distance as indicated in parts (c), (d), (e) and (f) which are calculated for a distance of 0.2 µm, 1 µm, 2µm and 3µm resp. The parts (g) and (h) are calculated for a distance of 5001 µm and 5002 µm resp. and show the z-invarinat behaviour at that distance where the image is z-invariant or in other words stationary.

The limited spatial and temporal coherence requirements of the technique make it possible to use commercial stand-alone sources such as plasma and gas-discharge sources in the EUV range in association with the described technique. These sources are being developed to be used in future EUV lithography systems and they are commercially available.

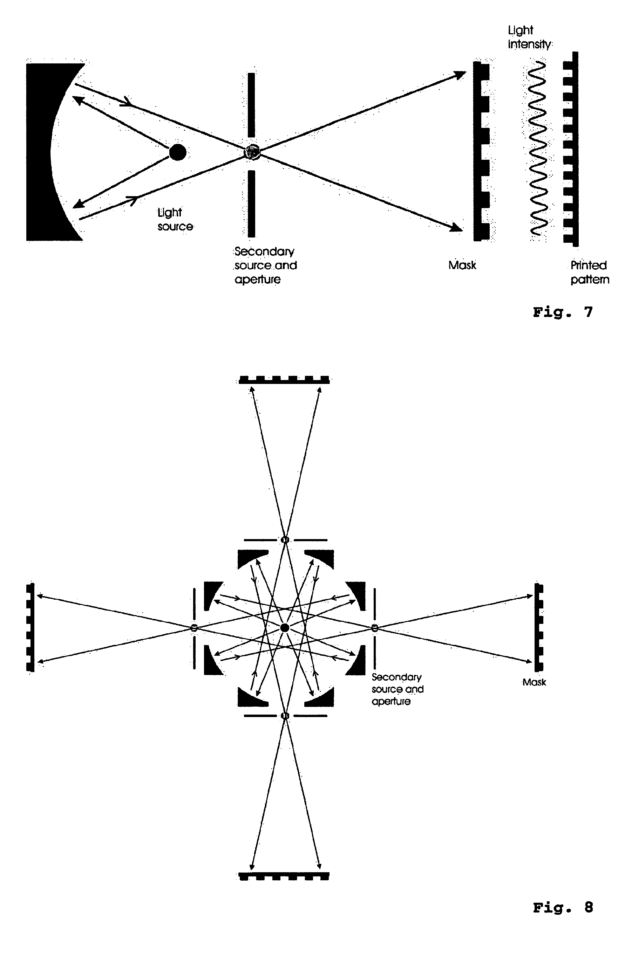

Figure 7 schematically shows a possible optical layout of a lithography system using such a source. The light from the source is collected by reflective optics (grazing incidence or multilayer coated for near normal incidence) and focused to form an image. Apertures can be introduced in or near this image plane to further define the source size according to the requirements of the lithography tool. The divergence of the beam can also be adjusted in this way. Other elements can be included in the system to prevent contamination from the source from reaching the mask. One or more filters can be placed in the beam at various positions to eliminate undesired parts of the emission spectrum from the source.

The EUV sources have sufficient power and spatial coherence to enable high volume production through the described technique. Very efficient use of the light from the source is used in this system since the number of optical elements is limited and all the diffracted orders from the mask are used in exposing the resist. This last point is in contrast to other interference lithography systems that make use of only one diffracted order from such a periodically patterned mask. The throughput available from a single source can be further increased by using a multiplexing scheme like the one shown in Figure 8. It is illustrated that multiple samples S can be exposed simultaneously using a single source. The schema shows a possible layout where four exposure systems are put together around a single source.

The technique introduces a new way of making nanometer scale periodic patterns over large areas with high throughput. Currently, electron-beam lithography can be used to fabricate such patterns. But being a serial process with low throughput, the cost is prohibitively high for commercial exploitation. Other important drawbacks of e-beam lithography include the necessity to use conducting substrates to avoid charging, and the proximity effect due to the long range of secondary electrons created in the sample.
Alternatively, mechanical techniques, such as nanoimprint lithography can be used to fabricate such patterns. This technique requires templates that have the same resolution as the end product. The templates are typically made by e-beam lithography. The lifetime of these templates is limited due to the physical contact made with each substrate. Therefore the nanoimprint method relies on e-beam lithography for supplying masters in sufficient quantities. Moreover the contact with the substrate may lead to additional problems in the process. Some sensitive substrates may be damaged by the applied pressure in the imprinting step. In addition, topography of the substrates has to be carefully controlled to allow a uniform and close contact with the template. This can exclude samples with inherent topographical features.
The technique described in this invention overcomes all of the difficulties mentioned above for competing techniques. Being a parallel process and making efficient use of the available light, the throughput is high. By using light in the EUV region (e.g. 13 nm wavelength) the resolution limit for the period is about 7 nm (half of the wavelength). The proximity effect that severely affects e-beam lithography is practically nonexistent due to the short range of secondary electrons created by EUV light. The charging of samples has no effect on the resolution since photons are used in the exposure. There is no physical contact with the sample to cause damage to it.
The obtained patterns in general have higher resolution than the mask. This relaxes the requirements on the fabrication process for the mask. A particularly appealing possibility is to use laser interference lithography (LIL) to make large area masks that can then be demagnified using the described process using EUV light. The LIL created mask can be used either directly or they can be used to make higher resolution masks.

The image is space invariant. Therefore the positioning of the sample in the z-direction is not critical. The distance between the mask and the sample is in the order of hundreds of microns or millimeters. Therefore the technique is not a proximity printing technique. This large working distance eliminates the risk of physical damage to the mask from coming into physical contact with the substrate or with possible particles that may have landed on the sample. The large depth of field also makes it possible to record patterns over substrates that possess substantial topography. This large distance may also help with the introduction of gases between the mask and the sample if this is desired for reasons such as the temperature stabilization of the mask.
1. H. H. Solak, C. David, J. Gobrecht, *Fabrication of high-resolution zone plates with wideband extreme-ultraviolet holography,* Appl. Phys. Lett. *in press*
2. H.H. Solak, C. David, *Method for generating a circular periodic structure on a basic support material,* EP 30003392, 14.2.2003.
3. T. A. Savas, S. N. Shah, M. L. Schattenburg, J. M. Carter, H. I. Smith *Achromatic interferometric lithography for 100-nm-peri od gratings and grids,* J. Vac. Sci. Technol. B 13, 2732 (1995).
4. D. C. Flanders, H. I. Smith, *Spatial period division exposing,* US Patent 4,360,586

## Claims

1. A system for generating periodic and/or quasi-periodic pattern on a sample (S) by using an interference lithography technique, comprising:
a) a photon source (P) emitting photons being substantially incoherent in time;
b) a mask (M) having a periodic or quasi-periodic pattern that corresponds to the desired pattern; said mask (M) being disposed at a first distance from the photon source (P) or after intermediate optical elements such as collimators, collectors, mirrors, lenses, filters and apertures.;
c) a sample holder for holding the sample (S) being disposed in a second distance from the mask (M) on the side opposite to the photon source (P), thereby the second distance is chosen to be in a range where the intensity distribution is substantially stationary and distance-invariant.

2. The system according to claim 1,
**characterized in that**
the photon source (P) emits dominantly photons having a wavelength in the range of 1 to 100 nm, preferably 10 to 50 nm.

3. The system according to claim 1 or 2,
**characterized in that**
the photon source (P) is a plasma source, such as a laser produced plasma source, or a gas discharge source.

4. The system according to any of the preceding claims,
**characterized in that**
the mask (M) has a linear grating or a two-dimensional linear grating or a two-dimensional partially non-linear grating or a two-dimensional periodically circular grating or a two-dimensional non-periodically circular grating.

5. The system according to any of the preceding claims,
**characterized in that**
the first distance is at least 1 mm.

6. The system according to any of the preceding claims,
**characterized in that**
the second distance is larger than the period of the grating of the mask, preferably in the range of 10 to 10⁵ times the period.

7. The system according to any of the preceding claims,
**characterized in that**
the photon source (P) has a substantially isotropic radiation characteristic, and a plurality of mask/sample holder arrangements are displaced around the photon source.

8. A method for generating periodic and/or quasi-periodic pattern on a sample (S) by using an interference lithography technique, comprising:
a) providing a photon source (P) emitting photons being substantially incoherent in time;
b) providing a mask (M) having a periodic or quasi-periodic pattern that corresponds to to the desired pattern;
c) disposing said mask (M) at a first distance from the photon source (P) or after intermediate optical elements such as collimators, collectors, mirrors, lenses, filters and apertures.;
d) providing a sample holder for holding the sample (S)
e) disposing the sample (S) at a second distance from the mask (M) on the side opposite to the photon source (P),
f) choosing the second distance to be in a range where the intensity distribution is substantially stationary and distance-invariant; and
g) illuminating the sample (S) with the radiation originating from the photon source (P) and passing through the mask (M).

9. The method according to claim 8,
**characterized in that**
the emitted light from the source is shaped and filtered by a number of optical elements, such as mirrors, lenses, apertures, gratings and filters.

10. The method according to claims 8 or 9,
**characterized in that**
the source of radiation is a synchrotron radiation source such as an insertion device or bending magnet

11. The method according to any of the preceding claims 8 to 10, **characterized in that**
the mask and/or the sample are scanned together or independently to form a desired dose distribution on the sample.

12. The method according to any of the preceding claims 8 to 11, **characterized in that**
the illuminating beam is scanned across the mask and the sample.

13. The method according to any of the preceding claims 8 to 12, **characterized in that**
the sample is displaced in position or angle between multiple exposures to form a desired dose distribution on the sample.

14. The method according to any of the preceding claims 8 to 13, **characterized in that**
a stationary or flowing gas is introduced on one or both sides of the mask to remove heat and/or prevent contamination from the source or the sample.
